Europäisches Patentamt

European Patent Office

Office européen des brevets

(19)

(11) **EP 0 488 717 B1**

(12) **EUROPEAN PATENT SPECIFICATION**

(45) Date of publication and mention
of the grant of the patent:
**09.04.1997 Bulletin 1997/15**

(51) Int Cl.6: **H01L 39/14**, H01L 39/24

(21) Application number: **91310994.8**

(22) Date of filing: **28.11.1991**

(54) **Oxide superconductor magnetic shielding material and method of manufacturing the same**

Material aus supraleitendem Oxyd für magnetische Abschirmung und Verfahren zu seiner Herstellung

Matériau en oxyde supraconducteur pour écran magnétique et procédé pour sa fabrication

(84) Designated Contracting States:
**DE FR GB**

(30) Priority: **29.11.1990 JP 332025/90
28.02.1991 JP 58414/91**

(43) Date of publication of application:
**03.06.1992 Bulletin 1992/23**

(73) Proprietor: **NGK INSULATORS, LTD.
Nagoya City Aichi Pref. (JP)**

(72) Inventors:
• **Shimizu, Hideki, 205 NGK Minamishataku
Nagoya City, Aichi Prefecture 467 (JP)**
• **Tani, Makoto
Inazawa City, Aichi Prefecture 492 (JP)**

(74) Representative: **Paget, Hugh Charles Edward et al
MEWBURN ELLIS
York House
23 Kingsway
London WC2B 6HP (GB)**

(56) References cited:
EP-A- 0 339 801          EP-A- 0 393 932
EP-A- 0 458 043          US-A- 3 740 828

• **PATENT ABSTRACTS OF JAPAN, vol. 14, no.
380 (E-096) 16 August 1990 & JP-A-02 138 799**
• **PATENT ABSTRACTS OF JAPAN, vol. 12, no.
142 (M-692) 30 April 1988 & JP-A-62 263 880**
• **PATENT ABSTRACTS OF JAPAN, vol. 13, no.
376 (M-862) 21 August 1989 & JP-A-01 130 889**
• **PATENT ABSTRACTS OF JAPAN, vol. 14, no.
537 (E-100) 27 November 1990 & JP-A-02 228 099**
• **PATENT ABSTRACTS OF JAPAN, vol. 9, no. 275
(M-426) 2 November 1985 & JP-A-60 118 396**

## Description

The present invention relates to an oxide superconductor magnetic shielding material and, in particular, an oxide superconductor magnetic shielding material having a structure comprising a metal substrate, an intermediate layer, and an oxide superconductor layer, in which the intermediate layer is formed on the metal substrate by diffusion bonding, plating, thermal spraying, or vapor deposition, or a combination thereof.

It is known to use a space surrounded by a ferromagnetic material such as permalloy or ferrite for magnetic shielding. Further, there have been proposed many magnetic shielding devices, for example, utilizing the Meissner effect of superconductors for which vigorous research and development have been made in recent years. For instance, Japanese Patent Laid Open No. 1-134998 (1989) proposes to dispose a superconductor on the innermost side adjacent a space for magnetic shielding. Further, the present applicant has already proposed, in EPC Patent Application EP-A-0 393 932 (No. 90.303984.0), a magnetic shielding cylinder having at least two layers relative to a magnetic source to be shielded arranged in the order of the substrate and the superconductor layer from the side of the magnetic source.

However, practical magnetic shielding materials are still in a developing stage at present. When small superconductors are merely combined into a large size, no high magnetic shielding performance can be obtained, because magnetic field leaks through the combined portions. Therefore, in order to obtain a high magnetic shielding performance, it is necessary to obtain a superconductor in an integral form. However, as the size becomes larger, it becomes more difficult to integrally form the oxide superconductor, and moreover the apparatus for producing it becomes larger, which is not preferred from an industrial point of view.

On the other hand, for a practical large-sized magnetic shielding material, it is required to use metal or other robust material as a substrate to give it sufficient mechanical strength. In a case of forming an oxide superconductor layer on a metal substrate, there is a problem of causing reaction between the metal substrate and the oxide superconductor, in particular, in the Bi-Sr-Ca-Cu-O system superconductor. It is customary to form an intermediate layer made of noble metal or the like and form the oxide superconductor layer uniformly on the intermediate layer in order to prevent such reaction. However, it is difficult to form the intermediate layer uniformly over the large-sized metal substrate and, further, to form the oxide superconductor layer uniformly dn the intermediate layer. As a result uniform and excellent superconducting properties can not be obtained.

JP-A-02138799 discloses a magnetic shielding material having a metal substrate, an intermediate layer of silver formed on the substrate and an oxide superconductive material layer on the intermediate layer, so as to prevent the reaction between the superconductive material and the substrate when the shield is thermally treated in an oxygen atmosphere.

EP-A-0393932 also discloses a magnetic shielding material having a similar structure, in which the intermediate layer of a noble metal is formed on the substrate by plasma-spraying, and an oxidation-resistant metal, for example SUS 430, Inconel or Hastelloy, can be used for the substrate.

This document also states that the shielding material can be formed of a plurality of plates.

EP-A-0458043 was published after the priority date of the present application, therefore it is a prior art document under 54(3) EPC. This document also discloses a three-layer structure for a magnetic shielding material, in which the substrate can be made of stainless steel (JIS SUS 3162), the intermediate layer of silver is formed on the substrate by plasma-spraying, and an oxide superconductive layer is formed on the intermediate layer.

An object of the present invention is to provide a large-sized magnetic shielding material by easily and conveniently preparing a larger-sized oxide superconductor capable of giving particularly high superconducting properties.

According to one aspect of the present invention, there is provided an oxide superconductor magnetic shielding material as specified in claim 1.

According to another aspect of the present invention, there is provided a method of manufacturing an oxide superconductor magnetic shielding material as specified in claim 4.

In the present invention, since the oxide superconductor magnetic shielding material is obtained by forming an intermediate layer on the oxidation-resistant metal substrate by one of methods of diffusion bonding, plating, thermal spraying, vapor deposition and the combination thereof and forming an oxide superconductor layer on the intermediate layer, it is stable against thermal shocks in the cold/heat cycle, has high reliability and is extremely useful from the industrial point of view.

Further, a large-sized magnetic shielding material can be easily manufactured by joining together divisional members (i.e. sub-sections) of substrate with the intermediate layer. thereon and its magnetic shielding performance is excellent.

Figs. 1, 2, 3 and 4 are, respectively, explanatory views illustrating modes of preferred embodiments of the invention for the large-sized body obtained by joining divisional intermediate -layer-formed substrates, in which an intermediate layer is formed by diffusion bonding, plating, flame spraying, vapor deposition or combination thereof.

Figs. 5, 6 and 7 are, respectively, explanatory cross sectional views illustrating one preferred embodiment of the invention in which intermediate layers are formed on divisional members of metal substrate having flanged portions, followed by joining.

Figs. 8, 9, 10 and 11 are, respectively, explanatory cross sectional views showing one preferred embodiment of the invention of joining divisional intermediate-layer-formed substrates.

Description will now be made more specifically referring to the present invention.

The magnetic shielding material according to the present invention comprises a three-layered structure of a metal substrate, an intermediate layer and an oxide superconductor layer and, in the case of magnetic shielding, it is preferably constituted such that they are disposed from the side of the magnetic source to be shielded in the order of metal substrate, intermediate layer and oxide superconductor layer.

Preferred metal substrates used in the present invention are those capable of keeping the mechanical strength of the oxide superconductor magnetic shielding material, having good adhesion to the intermediate layer formed by a method which is diffusion bonding, plating, thermal spraying, vapor deposition or a combination of a plurality of those methods and being stable even after forming the oxide superconductor layer on the intermediate layer. For such a metal, an oxidation-resistant metal is used, for example, high alloys such as stainless steels (SUS430 and SUS310 : JIS specification), inconels (inconel 600 and inconel 625), incolloy and hasteloy.

Diffusion bonding has been utilized generally as a method of bonding different kinds of metals firmly to each other. The technique of plating, thermal spraying and vapor deposition have been widely utilized as methods of coating a metal on a different kind of metal substrate. When a substrate consists of a metal, such as iron, nickel, copper or SUS304, that is usually employed as a substrate of the magnetic shielding material and an intermediate layer forms thereon by one of methods of diffusion bonding, plating, thermal spraying, vapor deposition and the combination thereof (hereinafter simply referred to as diffusion bonding, plating, thermal spraying, vapor deposition and the like), it is necessary to severely control the sintering conditions compared with a case of using a known single substrate, because an intense oxidation of the substrate metal generally occurs to reduce the adhesion to the intermediate layer in the known sintering conditions under the oxygen-rich atmosphere indispensable for oxide superconductors. Further, when a noble metal such as gold or silver is used as an intermediate layer formed by means of diffusion, plating, thermal spraying, vapor deposition or the like, sintering conditions have to be controlled further severely, since the metal substrate is more oxidized by an oxygen gas dissolved in the intermediate layer of noble metal at high temperature.

The foregoing problems occurring under the sintering conditions as described above have been recognized as a result of earnest studies made by the present inventors on the bonding strength of the intermediate layer portion formed by means of diffusion bonding, plating, thermal spraying, vapor deposition or the like at a high temperature and in an oxygen-rich atmosphere. Thus, the application of the oxidation-resistant metal substrate according to the present invention has been accomplished based on the above-mentioned findings.

In the present invention, the oxidation resistance of the metal substrate is suitably such that weight increase under oxidation when the substrate is placed in an oxidizing atmosphere at 900°C for 24 hours is less than 0.25 mg/cm$^2$, preferably, less than 0.2 mg/cm$^2$ wherein the unit of "mg/cm$^2$" means a weight increase per cm$^2$ of surface of the substrate under oxidation. There is no particular restriction on the thickness of the oxidation-resistant metal substrate in the present invention.

As the intermediate layer in the present invention, any of materials may be used so long as it is disposed between the substrate and the oxide superconductor layer and can be formed on the metal substrate by means of diffusion bonding, plating, thermal spraying , vapor deposition or the like. For example, there can be mentioned noble metals such as silver and gold. Among the noble metals, silver is generally used because of its inexpensiveness. Further, it is necessary for the intermediate layer to prevent the reaction between the metal substrate and the oxide superconductor layer. In particular, heat resistant material such as stainless steel maintaining its structure up to the sintering temperature for the oxide superconductor causes an intense reaction with the oxide superconductor during sintering, and therefore, the superconducting properties of the resultant oxide superconductor would be reduced if no intermediate layer were disposed for the prevention of the reaction. Using a noble metal as the intermediate layer can prevent the reaction described above.

In addition, since the modulus of elasticity of noble metals is generally smaller than that of metal substrates, it is also preferred that the noble metal functions as a moderator of a stress due to thermal shock exerted thereon in the cold/heat cycle ( the material is alternately placed in a cryogenic temperature region such as in a liquid nitrogen for showing the superconducting properties and a room temperature region ), which cycle is inevitable in the case of using the superconductor as a magnetic shielding material. It also functions moderating a thermal stress due to the difference in the thermal expansion between the metal substrate and the oxide superconductor layer in the cold/heat cycle.

Though noble metals are more expensive than usual metals, the thickness of the noble metal can be reduced by reinforcement with the oxidation-resistant metal substrate, to lower the cost, compared with the case of using a noble metal alone for the substrate. It can suffice that the intermediate layer has a thickness effective to the prevention of the reaction.

The thickness can be decided appropriately so as to minimize the thermal stresses formed, depending on physical properties such as thermal expansion coefficient, modulus of elasticity and mechanical strength of each of the materials for the oxide superconductor layer, the metal substrate and the intermediate layer, and on the thicknesses of the oxide superconductor layer and the metal substrate. For instance, in a case of using a noble metal such as gold or silver for the intermediate layer, the reaction can be prevented if the thickness of the intermediate layer is greater than 30 $\mu$m.

When a heat-resistant metal such as stainless steel or inconel is used for the metal substrate, it is preferred to make the thickness of the intermediate layer greater than 50 $\mu$m in view of the thermal expansion coefficients, moduli of elasticity and mechanical strength of the oxide superconductor layer, metal substrate and intermediate layer, since the effect as the moderating material described above can be fully attained.

If the thickness of the noble metal intermediate layer is greater than 700 $\mu$m, the thermal stress due to the difference of the thermal expansion between the oxide superconductor and the noble metal intermediate layer may become predominant rather than the effect as the moderating material. Further, the cost is undesirably increased with no improvement for the effect as the moderating material in proportion to the thickness of the noble metal. Accordingly, the thickness of the noble metal intermediate layer is preferably from 50 to 700 $\mu$m and, more preferably, from 100 to 600 $\mu$m.

In the present invention, since the intermediate layer is formed on the metal substrate by method of diffusion bonding, plating, thermal spraying, vapor deposition or the like as described above, a form of material for an intermediate layer can be selected according to the method used.

In the case of forming the intermediate layer by diffusion bonding, since it is formed by pressure sealing as described below, it is generally possible to use a foil or a thin plate having the above-mentioned thickness and being formed in accordance with the shape of the substrate to which the layer is diffusion-bonded. The diffusion bonding is such a bonding method developed in recent years for metals which are impossible to be welded to each other, thereby forming a clad material having both properties of the different metals to be bonded. It is referred as diffusion bonding since both of the metals to be bonded form a state of diffusion at the bonded boundary. In the present invention the diffusion bonding means such a state that the metal substrate and the intermediate layer material form a diffusion state at their bonded boundary.

As a method of the diffusion bonding, for instance, a metal substrate is surface-finished by means of polishing and ultrasonic cleaning, then press-bonded with an intermediate layer material plate at a high temperature of about 800 to 1100°C in a reducing gas atmosphere such as an argon (Ar) gas under a pressure of about 0.5 to 1.5 kg/mm$^2$ and, subsequently, finishing treatment such as removal of strains and polishing is applied thereto. Another method of the diffusion bonding is that surface-finishing such as polishing or ultrasonic cleaning is applied to both a metal substrate and an intermediate layer material, and they are put together and then hot-rolled, followed by the finishing treatment in the same manner as described above.

In the case where the intermediate layer is formed by plating, it can be attained, for example, by degreasing the surface of a metal substrate using an organic solvent; applying an acid activation thereto; subsequently, applying nickel strike (electrolytic treatment in a nickel chloride bath) and/or silver strike (electrolytic treatment in a silver chloride bath) in order to improve the adhesion of the plated layer; and electrodepositing a noble-metal plating layer thereon.

In the case of using thermal spraying, forming the intermediate layer can be attained, for instance, by previously roughing the surface of a metal substrate with sand blasting or the like and, subsequently, thermal-spraying a noble metal layer. Arc flame spraying such as powder flame spraying or wire flame spaying can be used. The form of the material to be thermal sprayed can be selected in accordance with the thermal spraying method employed.

In the case of using vapor deposition, physical or chemical vapor deposition such as spattering or laser deposition may be used.

The intermediate-layer-formed substrate prepared by forming an intermediate layer on a metal substrate or divisional members constituting a metal substrate by means of diffusion bonding, plating, thermal spraying, vapor deposition or the like as described above has less distortion, and therefore, a uniform oxide superconductor layer can be formed on the intermediate layer.

The oxide superconductors in the present invention have no particular restriction. They can be any of oxide superconductors such as rare earth oxide superconductors having a multi-layered perovskite structure with such general compositions of M-Ba-Cu-O in which M is at least one rare earth element selected from Sc, Y and lanthanides such as La, Eu, Gd, Er, Yb and Lu. Also, they can be bismuth (Bi) system superconductors having a composition, for example, represented by $Bi_2Sr_2Ca_1Cu_2O_x$ or $Bi_2Sr_2Ca_2Cu_3O_x$.

The magnetic shielding material according to the present invention can be obtained by forming the oxide superconductor layer on the intermediate layers which is formed on the substrate by means of diffusion bonding, plating, thermal spraying, vapor deposition or the like. The oxide superconductor magnetic shielding material obtained in the present invention has excellent superconductive properties and can exhibit stable magnetic shielding performance even when it is used repeatedly in the cold/heat cycle reciprocating between a room temperature and a cryogenic temperature such as a liquid nitrogen temperature for showing the superconducting properties.

When the magnetic shielding material is a large structure, for example, panel, cylindrical body and the like, it is obtained by forming an intermediate layer of plural divisional members constituting a metal substrate for the large structure having a predetermined shape, by means of diffusion bonding, plating, thermal spraying, vapor deposition or the like, to prepare plural divisional intermediate-layer-formed substrates; joining the divisional intermediate-layer-formed substrates into a large-sized metal substrate with the intermediate layer; and then forming an oxide superconductor layer on the intermediate layer.

The divisional intermediate-layer-formed substrate, which is prepared by forming the intermediate layer on the divisional member by means of diffusion bonding, plating, thermal spraying, vapor deposition or the like as described above, is preferably obtained as a flat plate form. Generally, when a large flat plate is integrally made, the installation cost is increased because a large scale apparatus is needed. Accordingly, it is extremely useful from the industrial point of view to previously prepare a plurality of relatively small divisional intermediate-layer-formed substrates and then to join the divisional intermediate-layer-formed substrates into a large-sized cylindrical form or a large-sized flat plate to each other by welding or the like.

Further, in the case of obtaining an elongate cylindrical body, an intermediate layer can be formed on one or both of circumferential surfaces of each of short cylindrical members by means of diffusion bonding, thermal spraying, vapor deposition or the like to prepare cylindrical intermediate-layer-formed substrates and then one end of them can be adjusted and joined to each other and into an elongate cylindrical substrate with an intermediate layer.

According to the present invention, in the oxide superconducting magnetic shielding material, the oxide superconductor layer is formed in an integral form on the large-sized intermediate-layer-formed substrate obtained by joining plural (two or more) divisional intermediate-layer-formed substrates to each other as described above.

There is no particular restriction on the thickness of the oxide superconductor layer. The thickness may properly be selected depending on the superconducting properties, the oxide superconductor material and the like so that required magnetic shielding performance can be obtained.

Furthermore, in the present invention it is also possible to obtain a magnetic shielding material having oxide superconductor layers formed on the both surfaces of intermediate layers which are formed on the both of top and bottom surfaces of divisional members of substrate in the same way as described above.

In the present invention, any of known methods can be employed for forming an oxide superconductor layer on an intermediate layer. For example, there can be employed the spray coating method using a slurry containing the starting material for an oxide superconductor or the doctor blading method or the press molding method. Usually, the spray coating method or the doctor blading method is used for an oxide superconductor layer of 200 to 500 $\mu$m, and the press molding method is preferred for an oxide superconductor layer of 0.5 to 5 mm thickness. Subsequently, sintering is carried out in an oxygen-rich-gas atmosphere at a temperature of about 800 to 1000°C to form an oxide superconductor layer. In particular, in the case of a Bi-system oxide superconductor, it is preferred to carry out a sequence of treatments comprising partial melting in an atmosphere of an oxygen-rich gas such as an oxygen gas at a temperature between 875 and 900°C, annealing at a cooling rate of less than 1°C/min down to about 850°C or under, maintaining the temperature for more than about 5 hours and, subsequently, heat-treating at a temperature of 450 to 700°C in an inert gas such as a nitrogen gas.

When the magnetic shielding material according to the present invention is of a bottomed cylinder, it is preferably shaped such that a portion connecting the cylindrical portion and the bottom portion is curved or angled obtusely. The radius R of curvature of the curved portion is preferably greater than 5 mm. It is not desirable that the bottom portion and the cylindrical portion are connected not by a curved or obtusely angled portion but by an acutely angled or a right-angled portion, or that the radius R of curvature of the curved portion is smaller than 5 mm, because the stress is concentrated to produce cracks in the connected portion by the thermal shock due to the cold/heat cycle, that is, the material is alternately placed in between a room temperature and a cryogenic temperature such as one in liquid nitrogen for showing the superconducting properties, by which the performance of magnetic shielding material obtained is remarkably deteriorated.

## EXAMPLES

Preferred embodiments of the present invention will now be described in more detail with reference to the drawings. However, the present invention is not restricted to the following embodiments.

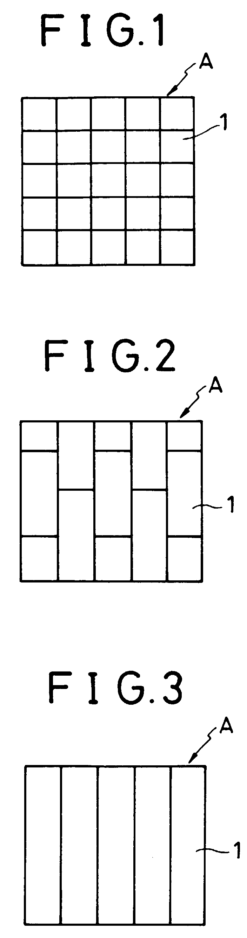

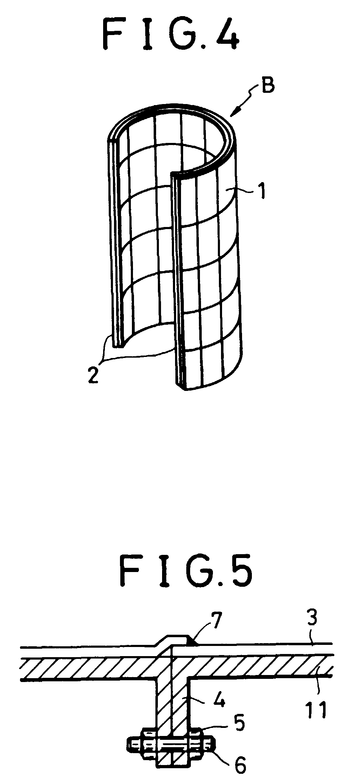

FIG. 1 through FIG. 4 are explanatory views for the large-sized body by joining divisional intermediate-layer-formed substrates obtained by forming an intermediate layer on each of divisional members constituting substrate for a magnetic shielding material using diffusion bonding, plating, thermal spraying, vapor deposition or the like as described above. In FIGS. 1 to 3, each of divisional intermediate-layer-formed substrates 1 with an intermediate layer formed by means of diffusion bonding, plating, thermal spraying, vapor deposition or the like on a divisional member, is joined into a large-sized flat-shaped plate A. Then, it is formed into a predetermined shape, for example, into a large-sized cylindrical form B as shown in FIG. 4 by means of roll forming or the like, and further, side portions 2 can be joined to each other in the same manner. Alternatively, respective divisional intermediate-layer-formed substrates can be previously shaped so that they are combined to a predetermined shape, for example, a cylindrical form and then joined to each other into the cylindrical form B shown in FIG. 4. Also, a bottomed cylindrical shape can be obtained by preparing a bottom substrate in an integral body or as divisional bottom members divided a bottom substrate and joining divisional bottom members to each other and/or to the cylindrical portion in the same manner as the cylindrical portion. For the joining of the divisional intermediate-layer-formed substrates described above, several embodiments of joint shown in FIG.1 through FIG. 3 can be applied. Usually, preferred joints are in the order of linear, T-shaped and cross-shaped configuration in view of strength and uniformity of the joints. Thus, preferred joints can be obtained by the structures in the order of FIG. 3, FIG. 2 and FIG. 1.

In the joining of the divisional intermediate-layer-formed substrates, substrate layers and intermediate layers are joined to the same kind layers, respectively.

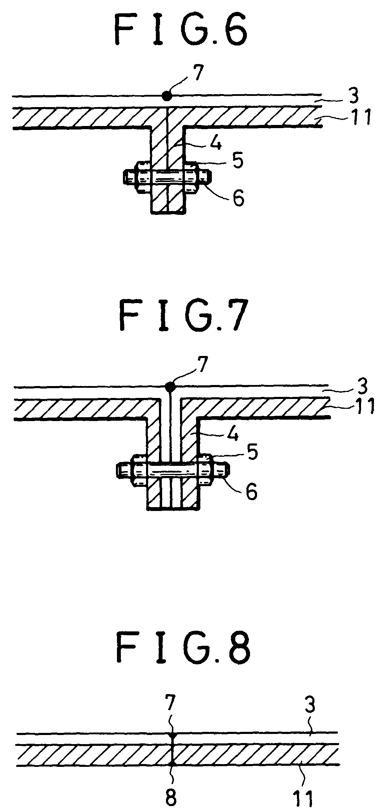

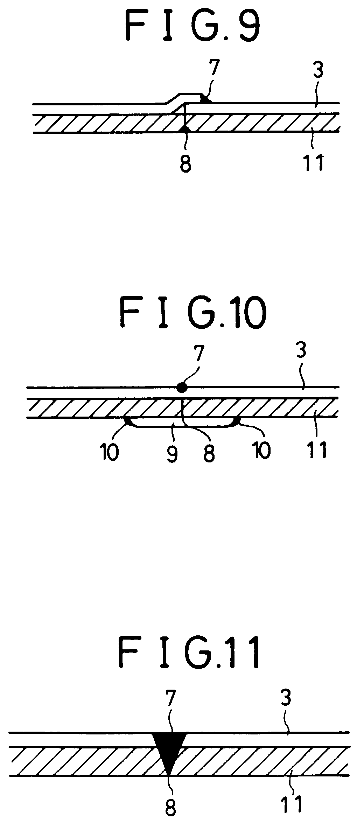

Usually, the substrate layers of divisional intermediate-layer-formed substrates can be joined to each other by means of welding or using flanges and the intermediate layers by means of welding joint or paste joint, respectively. Joining for the divisional intermediate-layer-formed substrates in the present invention includes various modes. Typical joining modes are shown in FIG. 5 through FIG. 11. FIG. 5 through FIG. 7 show embodiments in which a flange is disposed to a divisional substrate 11 and flanged portions 4 are joined by means of a nut 5 and a bolt 6; FIG. 8 through FIG. 11 show embodiments in which the joints 8 of the divisional substrates are abutted each other and joined by welding; FIG. 8 and FIG. 9 show simple build-up welding; FIG. 10 shows a method for using a welding strap plate 9 for welding its both ends 10, 10 with the divisional metal substrates 11; FIG. 11 shows a method for welding the metal substrate 11 and the intermediate layer 3 from the side of the intermediate layer.

Further, the intermediate layer formed on the divisional member of substrate by means of diffusion bonding, plating, thermal spraying, vapor deposition or the like can also be joined using various kinds of modes in accordance with the mode of joining the divisional substrates. For instance, in FIG. 5 and FIG. 6, the Ag intermediate layer 3 is formed on the divisional metal substrates 11 except the flanged portions 4 by means of diffusion bonding, plating, thermal spraying, vapor deposition or the like, while in FIG. 7, the intermediate layer is formed on the divisional members of metal substrates 11 including the flanged portions 4. In FIG. 8 through FIG. 11, the intermediate layer is formed on the divisional members metal substrates 11 having no flanges.

As has been described above, the intermediate layers, formed on the divisional members of metal substrates by means of diffusion bonding, plating, thermal spraying, vapor deposition or the like, are also joined to each other to constitute a large-sized body for magnetic shielding material. The intermediate layers can be joined in accordance with the mode of joining the divisional substrates as described above. For instance, in the modes shown in FIG. 5 and FIG. 9, the ends of two Ag plates are stacked by extending one of the Ag plates as far as above the other, and a contact 7 between the upper Ag plate and the lower Ag plate is joined by means of welding or using Ag paste. In the modes shown in FIGS 6, 7, 8 and 10, Ag intermediate layers are joined at the contact 7 thereof by means of welding or using the Ag paste. In the case of joining by using the Ag paste, heating was applied at about 800 to 900°C after the coating of the Ag paste, to complete the joining.

In the case of disposing flange(s) to the divisional substrate, it is preferred to curve or cut the orthogonal contact between the flat plane of the substrate and the flanged portion to round the corner portion. By forming such a corner portion, swelling upon joining the intermediate layers can be reduced to obtain a smooth joint.

Upon welding the metal substrates and the intermediate layers respectively in FIG. 5, FIG. 6 and FIG. 8 through FIG. 10, if the melting point of the metal substrate greatly differs from that of the intermediate layer, the lower melting one can be melted partially upon welding the higher melting one. In such a case, there is no requirement to apply welding for the entire joining cross section but it may be suffice to satisfy the practical mechanical strength by using build-up welding or the like.

Examples 1 to 9, not being embodiments of the invention

Each of metal substrates and Ag plates as the intermediate layer of which materials and sizes are shown in Table 1 was polished and then surface-finished by ultrasonic cleaning. Then, the Ag plate was placed on the metal substrate after the surface finishing and then bonded under pressure while being maintained for 120 minutes in an Ar gas atmosphere at 800 to 950°C and under a pressure of 0.5 to 1.5 $kg/mm^2$. Adhesion of the diffusion bonding for the specimens thus prepared was measured by a test method for clad steel according to JIS G0601. As a result, each of the specimens had a bonding strength of greater than 6 $kg/mm^2$ and had satisfactory adhesion.

Further, after straightening the strains resulting from the press-bonding, they were ground or polished to obtain substrates with diffusion-bonding intermediate layers.

On the Ag plates of the intermediate-formed substrates obtained in the above, starting materials $Bi_2Sr_2Ca_1Cu_2O_x$ dissolved in ethanol, toluene or isopropyl alcohol were applied to form a Bi-system oxide-superconductor-forming layer by the methods shown in Table 1. Subsequently, they were partially melted in an oxygen atmosphere at 885°C, annealed to 850°C at a cooling rate of 1°C/min, and kept at 850°C for 15 hours for crystallization, and then heat-treated in a nitrogen atmosphere at 500°C for 10 hours to form a Bi-system oxide superconductor layer having a thickness shown in Table 1. As a result, magnetic shielding materials were obtained.

The resultant magnetic shielding material was evaluated for the appearance by visual observation to judge its adequacy. Further, the following cold/heat cycle evaluation was conducted. The results are shown in Table 1.

In the cold/heat cycle evaluation, the resultant magnetic shielding material was immersed in liquid nitrogen and after the entire magnetic shielding material reached the liquid nitrogen temperature, it was maintained at that temperature for 30 minutes and the magnetic shielding performance was measured. Subsequently, the magnetic shielding material is taken out from the liquid nitrogen, left in the room-temperature atmosphere and then maintained for 30 minutes after the temperature of the entire magnetic shielding material reached the room temperature, which corresponds to one cycle. Then, the material was again immersed in the liquid nitrogen, maintained, measured for the magnetic shielding performance, taken out, left in the room-temperature atmosphere, and then maintained. Such cycles were repeated five times, and the magnetic shielding performance in the first and that in the fifth cold/heat cycles were compared by the following equation and evaluated as "○" for more than 80%, "Δ" for more than 50% and "×" for less than 50%.

$$\text{Cold/heat cycle evaluation (\%)} = \frac{\text{Magnetic shielding performance in fifth cold/heat cycle}}{\text{Magnetic shielding performance in first cold/heat cycle}} \times 100$$

Table 1

| | | Oxide superconductor magnetic shielding material | | | Metal substrate subsections | | Intermediate layer / Diffusion bonding conditions | | | | Bi-superconductor layer | | Sintering temp. in oxygen-enriched gas (°C) | Heat-treating temp. in nitrogen gas (°C) | Evaluation | |
|---|---|---|---|---|---|---|---|---|---|---|---|---|---|---|---|---|
| | | Mode | Shape | Size (mm) | Material | Oxidation resist(*1) | Ag-plate Thickness (μm) | Temp. (°C) | Pressure (kg/mm²) | Adhesion | Molding method (*2) | Thickness (μm) | | | Appearance | Cold/heat cycle |
| Example | 1 | Integral | Square | 100 ×100 | SUS430 | 1.9 | 300 | 900 | 1.0 | O | S | 300 | 855 | 500 | Good | O |
| | 2 | Integral | Square | 100 ×100 | SUS310S | 2.0 | 300 | 900 | 1.0 | O | S | 300 | 855 | 500 | Good | O |
| | 3 | Integral | Square | 100 ×100 | Inconel600 | 0.8 | 300 | 900 | 1.0 | O | S | 300 | 855 | 500 | Good | O |
| | 4 | Integral | Square | 100 ×100 | SUS302B | 2.5 | 300 | 900 | 1.0 | O | S | 300 | 855 | 500 | Good | O |
| | 5 | Integral | Square | 300 ×300 | Inconel625 | 0.7 | 300 | 900 | 1.0 | O | S | 300 | 855 | 500 | Good | O |
| | 6 | Integral | Square | 300 ×300 | Inconel625 | 0.7 | 300 | 900 | 1.0 | O | DB | 300 | 855 | 500 | Good | O |
| | 7 | Integral | Square | 300 ×300 | Inconel625 | 0.7 | 300 | 900 | 1.0 | O | P | 5mm | 855 | 500 | Good | O |
| | 8 | Integral | Square | 300 ×300 | Inconel625 | 0.7 | 100 | 900 | 1.0 | O | S | 300 | 855 | 500 | Good | O |
| | 9 | Integral | Square | 300 ×300 | Inconel625 | 0.7 | 500 | 900 | 1.0 | O | S | 300 | 855 | 500 | Good | O |
| comparative Example | 1 | Integral | Square | 100 ×100 | Iron | 140g/cm² | 300 | 900 | 1.0 | O | S | 300 | 855 | 500 | Ag/Metal peeled | — |
| | 2 | Integral | Square | 100 ×100 | Soft steel (C: 0.17%) | 83 | 300 | 900 | 1.0 | O | S | 300 | 855 | 500 | Ag/Metal peeled | — |
| | 3 | Integral | Square | 100 ×100 | Low carbon steel (C: 0.05%) | 220g/cm² | 300 | 900 | 1.0 | O | S | 300 | 855 | 500 | Ag/Metal peeled | — |
| | 4 | Integral | Square | 100 ×100 | SUS304 | 2.7 | 300 | 900 | 1.0 | O | S | 300 | 855 | 500 | Ag/Metal peeled | — |

(*1) Weight increase per cm² of surface area of metal substrate under oxidation when maintained in oxygen gas at 900 °C for 24 hours (mg/cm²)

(*2) S :Spray coating method, DB :Doctor blade method, P :Press shaping method

EP 0 488 717 B1

Comparative Examples 1 to 4

Bi system oxide superconductor magnetic shielding materials were obtained in the same procedure as in Example 1 except for using metal substrates shown in Table 1.

As a result of visual observation for the appearance of the resultant magnetic shielding materials in the same manner as in Example 1, the metal substrates and the Ag plates of the intermediate layer were broken away. Accordingly, they do not function as the magnetic shielding materials and the cold/heat cycle evaluation could not be carried out.

Examples 10 to 17

A required number of the divisional intermediate-formed substrates with diffusion-bonding Ag-intermediate layer were produced in the same procedure as in Example 1 using divisional members of metal substrate and Ag plates shown in Table 2. The resultant divisional diffusion-bonded intermediate-layer-formed substrates were joined respectively by each of the joining modes shown in Table 2 into large-sized substrates with diffusion-bonded intermediate layer, to form magnetic shielding materials of predetermined shape.

Magnetic shielding materials of each a predetermined shape were obtained by forming Bi-system oxide superconductor layer on the Ag plate of the resultant large-sized substrates in the same procedure as in Example 1 except for applying a heat treatment in a nitrogen atmosphere at 700°C.

For the resultant magnetic shielding materials, the appearance and the cold/heat cycle evaluation were carried out in the same manner as in Example 1. The results are shown in Table 2.

EP 0 488 717 B1

Table 2

| | | Oxide superconductor magnetic shielding material | | | | Member of metal substrate | | Intermediate layer | | | | | Bi-superconductor layer | | Sintering temp. in oxygen-enriched gas (℃) | Heat-treating temp. in nitrogen gas (℃) | Evaluation | |
|---|---|---|---|---|---|---|---|---|---|---|---|---|---|---|---|---|---|---|
| | | | | | | | | | | Diffusion bonding conditions | | | | | | | | |
| | | Mode | Shape | Size (mm) | Joining mode | Material Size(mm) | Oxida-tion re-sist [*1] | Ag-plate Thickness ($\mu$m) | Temp. (℃) | Pressure (kg/mm$^2$) | Adhesion | Molding method | Thick-ness ($\mu$m) | | | Appear-ance | Cold /heat cycle |
| Example | 10 | Large-sized | Square | 900 ×900 | FIG. 8 | Inconel625 300x300 | 0.7 | 5 0 0 | 9 0 0 | 1.0 | ○ | Spray coating | 300 | 8 8 5 | 7 0 0 | Good | ○ |
| | 11 | Large-sized | Cylinder | 300 $\phi$ ×500 | FIG. 8 | Inconel625 300x300 | 0.7 | 5 0 0 | 9 0 0 | 1.0 | ○ | Spray coating | 300 | 8 8 5 | 7 0 0 | Good | ○ |
| | 12 | Large-sized | Cylinder | 300 $\phi$ ×500 | FIG. 7 | Inconel625 300x300 | 0.7 | 5 0 0 | 9 0 0 | 1.0 | ○ | Spray coating | 300 | 8 8 5 | 7 0 0 | Good | ○ |
| | 13 | Large-sized | Cylinder | 300 $\phi$ ×500 | FIG. 9 | Inconel625 300x300 | 0.7 | 5 0 0 | 9 0 0 | 1.0 | ○ | Spray coating | 300 | 8 8 5 | 7 0 0 | Good | ○ |
| | 14 | Large-sized | Cylinder | 500 $\phi$ ×500 | FIG. 8 | Inconel625 300x300 | 0.7 | 5 0 0 | 9 0 0 | 1.0 | ○ | Spray coating | 300 | 8 8 5 | 7 0 0 | Good | ○ |
| | 15 | Large-sized | Cylinder | 650 $\phi$ ×2000 | FIG. 8 | Inconel625 300x600 | 0.7 | 5 0 0 | 9 0 0 | 1.0 | ○ | Spray coating | 300 | 8 8 5 | 7 0 0 | Good | ○ |
| | 16 | Large-sized | Bottomed Cylinder | 650 $\phi$ ×2000 | FIG. 8 | Inconel625 300x600 | 0.7 | 5 0 0 | 9 0 0 | 1.0 | ○ | Spray coating | 300 | 8 8 5 | 7 0 0 | Good | ○ |
| | 17 | Large-sized | Bottomed Cylinder | 1000 $\phi$ ×3000 | FIG. 8 | Inconel625 300x600 | 0.7 | 5 0 0 | 9 0 0 | 1.0 | ○ | Spray coating | 300 | 8 8 5 | 7 0 0 | Good | ○ |

[*1] Weight increase per cm$^2$ of surface area of metal substrate under oxidation when maintained in oxygen gas at 900 ℃ for 24 hours (mg/cm$^2$)

As apparent from the examples and the comparative examples described above, the substrates with diffusion-bonded intermediate layer obtained by using an oxidation-resistant metal as the substrate and were stable after applying treatments such as sintering at a high temperature in an oxygen-rich gas and forming an oxide superconductor layer thereon. It is clear that the materials enlarged by joining showed excellent and stable superconducting properties having a high magnetic shielding performance even after repeating cold/heat cycle.

Examples 18 to 22 and Example 26 not being embodiments of the invention

Each of the metal substrates each in the shape shown in Table 3 was degreased by using an organic solvent, applied to acid activation treatment. Subsequently, nickel striking and silver striking were applied successively to the surface of the substrate and a silver plating layer was formed thereon by electrodeposition up to a predetermined thickness. In each of the specimens thus produced, the adhesion between the silver plating layer and the metal substrate was satisfactory.

On the silver plating layer of the resultant silver-plated intermediate-layer-formed substrate, starting material $Bi_2Sr_2Ca_1Cu_2O_x$ dissolved in ethanol, toluene, ethylacetate or isopropyl alcohol was applied to form a Bi-system oxide superconductor layer by each of the methods shown in Table 1. Subsequently, it was partially melted at 885°C in an oxygen gas atmosphere and annealed down to 850°C at a cooling rate of 1°C/min and then kept at 850°C for more than 10 hours to grow crystals. Then, heat treatment was applied in a nitrogen atmosphere at 500°C for several hours to form Bi-system oxide superconductors each having a thickness shown in Table 1 to obtain magnetic shielding materials.

The appearance was evaluated for the resultant magnetic shielding materials by visual observation to judge their adequacy. Further, the cold/heat cycle evaluation was conducted in the same manner as in Example 1. The results are shown in Table 3.

Table 3

| | | Oxide superconductor magnetic shielding material | | | Member of metal substrate | | Intermediate layer | | | Bi-superconductor layer | | Sintering temp. in oxygen-enriched gas (°C) | Heat-treating temp. in nitrogen gas (°C) | Evaluation | |
|---|---|---|---|---|---|---|---|---|---|---|---|---|---|---|---|
| | | Mode | Shape | Size (mm) | Material Size(mm) | Oxida-tion re-sist[*1] | Thickness (mm) | Forming method (Form of Ag used) | Adhesion | Molding method | Thick-ness (μm) | | | Appear-ance | Cold /heat cycle |
| | 18 | Integral | Square | 100 ×100 | SUS430 100x100 | 1.9 | 0.2 | Ag Plating | ○ | Spray coating | 300 | 8 8 5 | 5 0 0 | Good | ○ |
| | 19 | Integral | Square | 100 ×100 | SUS310S 100x100 | 2.0 | 0.2 | Ag Plating | ○ | Spray coating | 300 | 8 8 5 | 5 0 0 | Good | ○ |
| | 20 | Integral | Square | 100 ×100 | Inconel600 100x100 | 0.8 | 0.2 | Ag Plating | ○ | Spray coating | 300 | 8 8 5 | 5 0 0 | Good | ○ |
| | 21 | Integral | Square | 100 ×100 | Inconel625 100x100 | 0.7 | 0.2 | Ag Plating | ○ | Spray coating | 300 | 8 8 5 | 5 0 0 | Good | ○ |
| Example | 22 | Integral | Square | 100 ×100 | SUS302B 100x100 | 2.5 | 0.2 | Ag Plating | ○ | Spray coating | 300 | 8 8 5 | 5 0 0 | Good | ○ |
| | 23 | Integral | Square | 100 ×100 | Inconel625 100x100 | 0.7 | 0.2 | Ag thermal spray (Ag powder) | ○ | Spray coating | 300 | 8 8 5 | 5 0 0 | Good | ○ |
| | 24 | Integral | Square | 100 ×100 | Inconel625 100x100 | 0.7 | 0.2 | Ag thermal spray (Ag wire) | ○ | Spray coating | 300 | 8 8 5 | 5 0 0 | Good | ○ |
| | 25 | Integral | Square | 100 ×100 | SUS302B 100x100 | 2.5 | 0.2 | Ag spattering(0.01mm) Ag thermal spray(0.19mm) | ○ | Doctor blade | 300 | 8 8 5 | 5 0 0 | Good | ○ |
| | 26 | Integral | Square | 300 ×300 | Inconel625 300x300 | 0.7 | 0.1 | Ag Plating | ○ | Press shaping | 5000 | 8 8 5 | 5 0 0 | Good | ○ |
| | 27 | Integral | Square | 300 ×300 | Inconel625 300x300 | 0.7 | 0.5 | Ag thermal spray (Ag powder) | ○ | Spray coating | 300 | 8 8 5 | 5 0 0 | Good | ○ |

[*1] Weight increase per cm² of surface area of metal substrate under oxidation when maintained in oxygen gas at 900 °C for 24 hours (mg/cm²)

EP 0 488 717 B1

Examples 23, 24 and 27 not being embodiments of the invention

After the surface of each of metal substrates each in the shape shown in Table 3 was roughened by sand blasting, arc flame spraying was applied by using silver in the form each shown in Table 3 to form a silver flame-sprayed layer on the metal substrate. In each of thus-produced specimens, the adhesion between the silver-sprayed layer and the metal substrate was satisfactory.

On the silver-flame-sprayed layer of the resultant intermediate-layer-formed substrate, a Bi-system oxide superconductor was formed in the same manner as in Example 18 to obtain each of Bi-system oxide superconductor magnetic shielding materials.

For the resultant magnetic shielding materials, the appearance and the cold/heat cycle evaluation was carried out in the same manner as in Example 1. The results are shown in Table 3.

Example 25 not being an embodiment of the invention

Vapor deposition by spattering was applied to a metal substrate in the shape shown in Table 3 in a vacuum vessel to form a vapor-deposited silver layer of 10 μm in thickness. Further, a silver-flame-sprayed layer was formed on the vapor-deposited silver layer in the same manner as in Example 23. In thus-prepared specimen, the adhesion between the silver-deposited and silver-flame-sprayed intermediate layer and the metal substrate was satisfactory.

On the silver-deposited and silver-flame-sprayed intermediate-layer-formed substrate, a Bi-system oxide superconductor was formed in the same manner as in Example 18 to obtain a Bi-system oxide superconductor magnetic shielding material.

For the resultant magnetic shielding material, the appearance and the cold/heat cycle evaluation was carried out in the same manner as in Example 1. The results are shown in Table 3.

Comparative Examples 5 to 11

Each of Bi-system oxide superconductor magnetic shielding materials was obtained in the same procedure as those in Examples 18, 23 and 25, except for using a metal substrate shown in Table 4.

For the resultant magnetic shielding materials, when the appearance was observed visually in the same manner as in Example 1, the metal substrate and the Ag plate of the intermediate layer were found broken away. Therefore, they did not function as the magnetic shielding materials and the cold/heat cycle evaluation could not be conducted.

Table 4

| | | Oxide superconductor magnetic shielding material | | | Metal substrate | | Intermediate layer | | | Bi-superconductor layer | | Sintering temp. in oxygen-enriched gas (℃) | Heat-treating temp. in nitrogen gas (℃) | Evaluation | |
|---|---|---|---|---|---|---|---|---|---|---|---|---|---|---|---|
| | | Mode | Shape | Size (mm) | Material Size(mm) | Oxidation re-sist[*1] | Thickness (mm) | Forming method (Form of Ag used) | Adhesion | Molding method | Thick-ness ($\mu$m) | | | Appearance | Cold /heat cycle |
| Example | 5 | Integral | Square | 100 ×100 | Iron 100x100 | 140g/cm² | 0.3 | Ag Plating | ○ | Spray coating | 300 | 8 8 5 | 5 0 0 | Ag/Substrate peeling | —— |
| | 6 | Integral | Square | 100 ×100 | Soft steel (C:0.17%) 100x100 | 8 3 | 0.3 | Ag Plating | ○ | Spray coating | 300 | 8 8 5 | 5 0 0 | Ag/Substrate peeling | —— |
| | 7 | Integral | Square | 100 ×100 | Low carbon steel (C:0.05%) 100x100 | 220g/cm² | 0.3 | Ag Plating | ○ | Spray coating | 300 | 8 8 5 | 5 0 0 | Ag/Substrate peeling | —— |
| Comparative | 8 | Integral | Square | 100 ×100 | SUS304 100x100 | 2.7 | 0.3 | Ag Plating | ○ | Spray coating | 300 | 8 8 5 | 5 0 0 | Ag/Substrate peeling | —— |
| | 9 | Integral | Square | 100 ×100 | SUS304 100x100 | 2.7 | 0.3 | Ag thermal spray (Ag powder) | ○ | Spray coating | 300 | 8 8 5 | 5 0 0 | Ag/Substrate peeling | —— |
| | 10 | Integral | Square | 100 ×100 | SUS304 100x100 | 2.7 | 0.3 | Ag thermal spray (Ag wire) | ○ | Spray coating | 300 | 8 8 5 | 5 0 0 | Ag/Substrate peeling | —— |
| | 11 | Integral | Square | 100 ×100 | SUS304 100x100 | 2.7 | 0.0 5 | Ag spattering | ○ | Spray coating | 300 | 8 8 5 | 5 0 0 | Ag/Substrate peeling | —— |

[*1] Weight increase per cm² of surface area of metal substrate under oxidation when maintained in oxygen gas at 900℃ for 24 hours (mg/cm²)

EP 0 488 717 B1

Examples 28 to 38

A predetermined number of divisional silver plated intermediate-layer-formed substrates were produced by using divisional members of metal substrates in the shapes and material shown in Table 5 in the same manner a in Examples 18 and 23. The resultant divisional intermediate-layer-formed substrates were joined to each other in the joining modes shown in Table 5 into the large-sized silver-plated intermediate-layer-formed substrate for magnetic shielding materials having a predetermined shape.

On the silver-plated layer of the resultant large-sized silver-plated intermediate-layer-formed substrates, Bi-system oxide superconductor layer was formed in the same manner as in Example 18, to obtain magnetic shielding materials having a predetermined shape.

For the resultant magnetic shielding materials, the appearance and the cold/heat cycle evaluation was conducted in the same manner as in Example 1. The results are shown in Table 3.

Table 5

| | | Oxide superconductor magnetic shielding material | | | | Metal substrate | | Intermediate layer | | | Bi-superconductor layer | | Sintering temp. in oxygen-enriched gas (℃) | Heat-treating temp. in nitrogen gas (℃) | Evaluation | |
|---|---|---|---|---|---|---|---|---|---|---|---|---|---|---|---|---|
| | | Mode | Shape | Size (mm) | Joining mode | Material Size(mm) | Oxidation re-sist [*1] | Thickness (mm) | Forming method (Form of Ag used) | Adhesion | Molding method | Thickness (μm) | | | Appearance | Cold /heat cycle |
| Example | 28 | Large-sized | Square | 900 ×900 | FIG. 5 | Inconel625 300x300 | 0.7 | 0.3 | Ag thermal spray (Ag Powder) | ○ | Spray coating | 300 | 8 8 5 | 5 0 0 | Good | ○ |
| | 29 | Large-sized | Square | 900x 900 | FIG. 6 | Inconel625 300x300 | 0.7 | 0.3 | Ag Plating | ○ | Spray coating | 300 | 8 8 5 | 5 0 0 | Good | ○ |
| | 30 | Large-sized | Square | 1000 ×1000 | FIG. 8 | Inconel625 500x500 | 0.7 | 0.2 | Ag thermal spray (Ag Powder) | ○ | Spray coating | 300 | 8 8 5 | 5 0 0 | Good | ○ |
| | 31 | Large-sized | Cylinder | φ300 ×500 | FIG. 9 | Inconel625 300x300 | 0.7 | 0.2 | Ag thermal spray (Ag Powder) | ○ | Spray coating | 300 | 8 8 5 | 5 0 0 | Good | ○ |
| | 32 | Large-sized | Cylinder | φ300 ×500 | FIG. 7 | Inconel625 300x300 | 0.7 | 0.2 | Ag Plating | ○ | Spray coating | 300 | 8 8 5 | 5 0 0 | Good | ○ |
| | 33 | Large-sized | Cylinder | φ300 ×500 | FIG. 7 | Inconel625 φ300 x250 | 0.7 | 0.2 | Ag Plating | ○ | Spray coating | 300 | 8 8 5 | 5 0 0 | Good | ○ |
| | 34 | Large-sized | Cylinder | φ300 ×500 | FIG. 7 | Inconel625 φ300 x250 | 0.7 | 0.2 | Ag thermal spray (Ag Powder) | ○ | Spray coating | 300 | 8 8 5 | 5 0 0 | Good | ○ |
| | 35 | Large-sized | Cylinder | φ500 ×500 | FIG. 7 | Inconel625 φ500 x250 | 0.7 | 0.2 | Ag thermal spray (Ag Powder) | ○ | Spray coating | 300 | 8 8 5 | 5 0 0 | Good | ○ |
| | 36 | Large-sized | Cylinder | φ650 ×2000 | FIG. 7 | Inconel625 300x600 | 0.7 | 0.2 | Ag Plating | ○ | Spray coating | 300 | 8 8 5 | 5 0 0 | Good | ○ |
| | 37 | Large-sized | Bottomed Cylinder | φ650 ×2000 | FIG. 7 | Inconel625 500x500 | 0.7 | 0.2 | Ag thermal spray (Ag Powder) | ○ | Spray coating | 300 | 8 8 5 | 5 0 0 | Good | ○ |
| | 38 | Large-sized | Bottomed Cylinder | φ1000 ×3000 | FIG. 7 | Inconel625 500x500 | 0.7 | 0.2 | Ag thermal spray (Ag Powder) | ○ | Spray coating | 300 | 8 8 5 | 5 0 0 | Good | ○ |

[*1] Height increase per $cm^2$ of surface area of metal substrate under oxidation when maintained in oxygen gas at 900℃ for 24 hours ($mg/cm^2$)

EP 0 488 717 B1

As apparent from the examples and comparative examples above, the intermediate-layer-formed substrate prepared by using the oxidation-resistant metal as the substrate and forming the intermediate layer material thereon by means of plating, thermal spraying, vapor deposition or the like is stable even after applying treatment such as sintering at a high temperature in an oxygen-rich gas, and forming an oxide superconductor layer thereon, and it is clear that all of the resultant large-sized magnetic shielding materials are stable to repeating cold/heat cycles and show excellent superconducting properties having a high magnetic shielding performance.

## Claims

1. An oxide superconductor magnetic shielding material comprising a structure having a metal substrate (11), an intermediate layer (3) on the substrate (11) and an oxide superconductor layer on the intermediate layer (3), in which the metal substrate (11) is oxidation-resistant and the intermediate layer (3) is formed on the metal substrate by one of the methods of diffusion-bonding, plating, thermal spraying and vapor deposition, or a combination thereof, characterised in that the metal substrate (11) is formed by a plurality of discrete metal members joined side-by-side with each member carrying a said intermediate layer (3), in that said oxide superconductor layer covers the joint or joints between said intermediate layers (3), and in that the oxidation resistance of the metal of the substrate (11) is such that its weight increase on oxidation in an oxygen atmosphere at 900°C for 24 hours is less than 2.5 mg/cm$^2$ of the surface area of the metal under oxidation.

2. A magnetic shielding material as defined in claim 1, wherein the intermediate layer (3) is made of a noble metal and has a thickness greater than 50μm.

3. A magnetic shielding material as defined in claim 1 or 2, wherein the magnetic shielding material is cylindrical or of panel shape and the metal substrate (11) comprises at least two members side-by-side with their intermediate layers (3) joined to each other.

4. A method of manufacturing an oxide superconductor magnetic shielding material, which comprises:

   (1) forming an intermediate layer (3) on each of a plurality of metal members (11) having a flat plate-shaped or part cylindrical shape and made of oxidation-resistant metal, by one of the methods of diffusion-bonding, plating, thermal spray, vapor deposition or a combination thereof;
   (2) joining said plurality of metal members (11) carrying said intermediate layers (3) side-by-side in a manner such that joints are made between the members and between the intermediate layers respectively; and
   (3) subsequently, forming an oxide superconductor layer on the joined intermediate layers (3) so that the oxide superconductor layer covers the joint or joints between the intermediate layers (3);

   wherein the oxidation resistance of the metal of the substrate (11) is such that its weight increase on oxidation in an oxygen atmosphere at 900°C for 24 hours is less than 2.5 mg/cm$^2$ of the surface area of the metal under oxidation.

5. A method as defined in claim 4, wherein the intermediate layer (3) is formed on the metal members (11) by diffusion-bonding in an inert gas atmosphere, at a high temperature and under a high pressure.

6. A method as defined in claim 4, wherein the intermediate layer (3) is formed on the metal members (11) by diffusion-bonding by using hot rolling.

7. A method as defined in claim 4, 5 or 6 wherein the body obtained by joining the metal members (11) is flat plate-shaped.

8. A method as defined in claim 4, 5 or 6, wherein the body obtained by joining the metal members (11) is a cylinder.

9. A method as defined in claim 8, wherein the cylinder is shaped from a body of flat plate shape obtained by joining the metal members (11).

10. A method as defined in claim 8, wherein the members (11) are previously shaped suitably to be combined into the cylinder.

11. A method as defined in claim 8, 9 or 10, wherein the cylinder has a bottom.

12. A method as defined in any one of claims 4 to 11, wherein the intermediate layer (3) is made of a noble metal and has a thickness greater than 50µm.

## Patentansprüche

1. Material zur magnetischen Abschirmung mit Oxidsupraleiter, umfassend eine Struktur mit einem Metallsubstrat (11), einer Zwischenschicht (3) auf dem Substrat (11) und einer Oxidsupraleiterschicht auf der Zwischenschicht (3), worin das Metallsubstrat (11) oxidationsbeständig ist und die Zwischenscnicht (3) auf dem Metallsubstrat nach einem der folgenden Verfahren oder mittels einer Kombination davon gebildet wird: Diffusions-Verbinden, Plattieren, thermisches Spritzen und Dampfablagerung, dadurch gekennzeichnet, daß das Metallsubstrat (11) durch eine Vielzahl diskrete, miteinander Seite-an-Seite verbundene Metallelemente gebildet ist, von denen jedes Element eine Zwischenschicht (3) trägt, daß die Oxidsupraleiterschicht die Verbindungsstelle oder Verbindungsstellen zwischen den Zwischenschichten (3) abdeckt und daß die Oxidationsbeständigkeit des Metalls des Substrats (11) solcherart ist, daß seine Gewichtszunahme durch 24-stündige Oxidation in einer Sauerstoffatmosphäre bei 900°C weniger als 2,5 mg/cm$^2$ der Oberfläche des oxidierten Metalls beträgt.

2. Material zur magnetischen Abschirmung nach Anspruch 1, worin die Zwischenschicht (3) aus einem Edelmetall besteht und eine Dicke von mehr als 50 µm aufweist.

3. Material zur magnetischen Abschirmung nach Anspruch 1 oder 2, worin das Material zur magnetischen Abschirmung zylindrisch oder plattenförmig ist und das Metallsubstrat (11) zumindest zwei Elemente Seite an Seite umfaßt, deren Zwischenschichten (3) miteinander verbunden sind.

4. Verfahren zur Herstellung eines Materials zur magnetischen Abschirmung mit Oxidsupraleiter, umfassend:

    (1) die Bildung einer Zwischenschicht (3) auf jedem einer Vielzahl Metallelemente (11), die die Form einer ebenen Platte oder eines Zylinderabschnitts aufweisen und aus oxidationsbeständigem Metall bestehen, nach einem der folgenden Verfahren oder mittels einer Kombination davon: Diffusions-Verbinden, Plattieren, thermisches Spritzen, Dampfablagern;
    (2) Seite-an-Seite-Verbinden der Vielzahl Metallelemente (11), die die Zwischenschichten (3) tragen, solcherart, daß Verbindungsstellen zwischen den Elementen bzw. zwischen den Zwischenschichten entstehen; und
    (3) anschließende Bildung einer Oxidsupraleiterschicht auf den verbundenen Zwischenschichten (3), sodaß die Oxidsupraleiterschicht die Verbindungsstelle oder Verbindungsstellen zwischen den Zwischenschichten (3) abdeckt;

    worin die Oxidationsbeständigkeit des Metalls des Substrats (11) solcherart ist, daß seine Gewichtszunahme durch 24-stündige Oxidation in einer Sauerstoffatmosphäre bei 900°C weniger als 2,5 mg/cm$^2$ der Oberfläche des oxidierten Metalls beträgt.

5. Verfahren nach Anspruch 4, worin die Zwischenschicht (3) auf den Metallelementen (11) durch Diffusions-Verbinden in einer Inertgasatmosphäre bei hoher Temperatur und unter hohem Druck ausgebildet wird.

6. Verfahren nach Anspruch 4, worin die Zwischenschicht (3) auf den Metallelementen (11) durch Diffusions-Verbinden mittels Heißwalzen ausgebildet wird.

7. Verfahren nach Anspruch 4, 5 oder 6, worin der durch Verbinden der Metallelemente (11) erhaltene Körper die Form einer ebenen Platte aufweist.

8. Verfahren nach Anspruch 4, 5 oder 6, worin der durch Verbinden der Metallelemente (11) erhaltene Körper ein Zylinder ist.

9. Verfahren nach Anspruch 8, worin der Zylinder aus einem Körper in Form einer ebenen Platte, der durch Verbinden der Metallelemente (11) erhalten wurde, geformt wird.

10. Verfahren nach Anspruch 8, worin die Elemente (11) zuvor in geeigneter Weise geformt werden, um sich zu dem Zylinder kombinieren zu lassen.

**11.** Verfahren nach Anspruch 8, 9 oder 10, worin der Zylinder einen Boden besitzt.

**12.** Verfahren nach einem der Ansprüche 4 bis 11, worin die Zwischenschicht (3) aus einem Edelmetall besteht und eine Dicke von mehr als 50 μm aufweist.

**Revendications**

**1.** Matériau de blindage magnétique en oxyde supraconducteur, comprenant une structure ayant un substrat en métal (11), une couche intermédiaire (3) sur le substrat (11) et une couche d'oxyde supraconducteur sur la couche intermédiaire (3), où le substrat en métal est résistant à l'oxydation et la couche intermédiaire (3) est formée sur le substrat en métal par l'une des méthodes de liaison par diffusion, placage, pulvérisation thermique et dépôt en phase vapeur ou bien une combinaison, caractérisé en ce que le substrat en métal (11) est formé par un certain nombre d'organes métalliques distincts joints côte-à-côte, chaque organe portant une couche intermédiaire (3), en ce que ladite couche d'oxyde supraconducteur couvre le joint ou les joints entre lesdites couches intermédiaires (3) et en ce que la résistance à l'oxydation du métal du substrat (11) est telle que son augmentation de poids à l'oxydation dans une atmosphère d'oxygène à 900°C pendant 24 heures soit inférieure à 2,5 mg/cm$^2$ de l'aire superficielle du métal en oxydation.

**2.** Matériau de blindage magnétique tel que défini à la revendication 1, où la couche intermédiaire (3) est faite d'un métal noble et a une épaisseur de plus de 50 μm.

**3.** Matériau de blindage magnétique tel que défini à la revendication 1 ou 2, où le matériau de blindage magnétique est cylindrique ou bien en forme de panneau et le substrat en métal (11) comprend au moins deux organes côte-à-côte avec leurs couches intermédiaires (3) jointes l'une à l'autre.

**4.** Méthode de fabrication d'un matériau de blindage magnétique en oxyde supraconducteur, qui consiste à :

(1) former une couche intermédiaire (3) sur chacun d'un certain nombre d'organes en métal (11) ayant une forme de plaque plate ou une forme partiellement cylindrique et faits en un métal résistant à l'oxydation, par l'une des méthodes de liaison par diffusion, placage, jet thermique, dépôt en phase vapeur ou une combinaison;
(2) joindre lesdits organes en métal (11) portant lesdites couches intermédiaires (3) côte-à-côte de manière que des joints soient faits entre les organes et entre les couches intermédiaires respectivement; et
(3) former subséquemment une couche d'oxyde supraconducteur sur les couches intermédiaires jointes (3), de manière que la couche d'oxyde supraconducteur couvre le joint ou les joints entre les couches intermédiaires (3);

où la résistance à l'oxydation du métal du substrat (11) est telle que son augmentation de poids à l'oxydation dans une atmosphère d'oxygène à 900°C pendant 24 heures soit inférieure à 2,5 mg/cm$^2$ de l'aire superficielle du métal en oxydation.

**5.** Méthode telle que définie à la revendication 4, où la couche intermédiaire (3) est formée sur des organes en métal (11) par liaison par diffusion dans une atmosphère d'un gaz inerte, à une haute température et sous une haute pression.

**6.** Méthode telle que définie à la revendication 4, où la couche intermédiaire (3) est formée sur les organes en métal (11) par liaison par diffusion en utilisant un laminage à chaud.

**7.** Méthode telle que définie à la revendication 4, 5 ou 6, où le corps obtenu en joignant les organes en métal (11) est en forme de plaque plate.

**8.** Méthode telle que définie à la revendication 4, 5 ou 6, où le corps obtenu en joignant les organes en métal (11) est un cylindre.

**9.** Méthode telle que définie à la revendication 8, où le cylindre est formé d'un corps en forme de plaque plate que l'on obtient en joignant les organes en métal (11).

**10.** Méthode telle que définie à la revendication 8, où les organes (11) sont au préalable configurés de manière appropriée pour être combinés en un cylindre.

**11.** Méthode telle que définie à la revendication 8, 9 ou 10, où le cylindre a un fond.

**12.** Méthode telle que définie selon l'une quelconque des revendications 4 à 11, où la couche intermédiaire (3) est faite d'un métal noble et a une épaisseur plus importante que 50µm.

# FIG.1

# FIG.2

# FIG.3

# F I G. 4

# F I G. 5

# F I G.6

# F I G.7

# F I G.8

# F I G.9

# F I G.10

# F I G.11